# EUROPEAN PATENT SPECIFICATION

(11) **EP 3 745 205 B1**
(45) Date of publication and mention of the grant of the patent: **14.07.2021**
(21) Application number: 20175706.9
(22) Date of filing: 20.05.2020
(51) Int. Cl.: G03F 7/033

(54) **FLEXOGRAPHIC PRINTING ORIGINAL PLATE AND METHOD FOR PRODUCING FLEXOGRAPHIC PRINTING PLATE**
FLEXOGRAFISCHE ORIGINALDRUCKPLATTE UND VERFAHREN ZUR HERSTELLUNG EINER FLEXOGRAFISCHEN DRUCKPLATTE
PLAQUE ORIGINALE D'IMPRESSION FLEXOGRAPHIQUE ET PROCÉDÉ DE PRODUCTION DE PLAQUE D'IMPRESSION FLEXOGRAPHIQUE

(30) Priority: 29.05.2019 JP 2019100050
(43) Date of publication of application: 02.12.2020
(73) Proprietor: Asahi Kasei Kabushiki Kaisha, Tokyo 1000006 (JP)
(72) Inventor: TABATA, Shusaku, Tokyo, 1000006 (JP); ANZAI, Nobuhiro, Tokyo, 1000006 (JP)
(74) Representative: Strehl Schübel-Hopf & Partner

(56) References cited:
- JP-A- H05 134 410
- JP-A- H11 249 305
- JP-A- 2000 181 060
- JP-A- 2014 157 191
- US-A1- 2009 155 721

## Description

### BACKGROUND OF THE INVENTION

### Field of the Invention

The present invention relates to a flexographic printing original plate, and a method for producing a flexographic printing plate.

### Description of the Related Art

A known photosensitive resin composition for use in a flexographic printing plate contains, for example, a thermoplastic elastomer, a photopolymerizable unsaturated monomer, a plasticizer and a photopolymerization initiator (see, for example, Japanese Patent Laid-Open Nos. 2000-155418 and 02-108632).

A known flexographic printing original plate for a flexographic printing plate has a structure in which a polyester film or the like is used as a support, a layer containing a photosensitive resin composition (a photosensitive resin composition layer) is stacked thereon, and if necessary, for purposes of smoothing contact with a negative film, a slip layer or a protective layer, or a UV shielding layer containing an infrared sensitive material removable by infrared laser is stacked on the photosensitive resin composition layer.

For plate-making of a flexographic printing plate from such a flexographic printing original plate, for example, the following method is generally employed. First, a thin uniform cured layer is provided by performing UV exposure (back exposure) on the entire surface through the support. Next, through a negative film, or directly from above the UV shielding layer, image exposure (relief exposure) is performed on a surface of the photosensitive resin composition layer, and an unexposed portion is washed away using a developing solvent, or is absorption removed using an absorption layer after thermal melting, followed by post-exposure.

A flexographic printing plate produced by the above-described method is used in printing on a film, paper, corrugated board and the like.

In recent years, lower grade paper is used in corrugated board, and a paper surface for printing is rough, and therefore, ink transferability in printing is deteriorated in printing on corrugated board.

As a method for coping with such a problem, a method for improving ink transferability in which the amount of ink reception from an anilox roll is increased by increasing a surface area of a printing plate by forming minute microcells on the surface of the printing plate by laser drawing technique has been proposed (see, for example, Japanese Patent Laid-Open No. 11-249305).

For determining arrangement of the microcells formed on the surface of the printing plate, however, it is necessary to perform many verifications, and an adequate arrangement pattern differs depending on the type of ink or print medium. Therefore, this method has a problem of complicated processes.

Accordingly, an object of the present invention is to provide a flexographic printing original plate from which a printing plate capable of attaining both ink filling inhibition and ink transferability in performing printing on low grade corrugated board can be obtained, and which exhibits high productivity in plate-making.

### SUMMARY OF THE INVENTION

The present inventors made earnest studies to solve the above-described problem, resulting in finding that the problem can be solved by a flexographic printing original plate including a support, and a photosensitive resin composition layer stacked on the support and containing specific constituent materials, and thus, the present invention was accomplished.

Specifically, the present invention is as follows.
[1] A flexographic printing original plate, including: a support; and a photosensitive resin composition layer stacked on the support, wherein the photosensitive resin composition layer contains: a thermoplastic elastomer (a), a photopolymerizable unsaturated monomer (b), a photopolymerization initiator (c), and a plasticizer (d), the thermoplastic elastomer (a) is a block copolymer that has a polymer block (A) principally containing at least one vinyl aromatic monomer unit, and a polymer block (B) principally containing at least one conjugated diene monomer unit, and that is represented by either of the following general formulas (I) and (II), the thermoplastic elastomer (a) has a weight average molecular weight of 100,000 or more and 200,000 or less, a content of a vinyl aromatic monomer unit in the thermoplastic elastomer (a) is 25.0% by mass or more, a content of vinyl bond based on a conjugated diene monomer unit in the thermoplastic elastomer (a) is 12.0% by mass or less, the thermoplastic elastomer (a) is less than 50 parts by mass based on 100 parts by mass of the photosensitive resin composition, the plasticizer (d) contains polybutadiene containing 70.0% by mass or more of cis-form, and a content of vinyl bond based on a conjugated diene monomer unit in the plasticizer (d) (I) is less than 5.0% by mass:

   (A-B)ₙ (I)

   (A-B)ₙX (II)

   wherein A represents the polymer block (A), B represents the polymer block (B), X represents a residue of a coupling agent or a residue of a polymerization initiator, and n represents an integer of 1 to 2.
[2] The flexographic printing original plate according to [1] described above, wherein the thermoplastic elastomer (a) contains a stearic acid salt or a stearic acid derivative as an antiblocking agent of the thermoplastic elastomer (a).
[3] A method for producing a flexographic printing plate, including the following steps performed on the flexographic printing original plate according to any one of [1] to [3] described above: a step of performing UV irradiation from a side of the support; a step of performing pattern exposure by UV irradiation on the photosensitive resin composition layer; and a step of removing an unexposed portion of the photosensitive resin composition layer.

According to the present invention, it is possible to obtain a flexographic printing original plate from which a printing plate capable of attaining both ink filling inhibition and ink transferability in performing printing on low grade corrugated board can be obtained, and which exhibits high productivity in plate-making.

### DETAILED DESCRIPTION OF THE PREFERRED EMBODIMENT

Now, an embodiment for practicing the present invention (hereinafter simply referred to as the "present embodiment") will be described in detail. The present embodiment described below is merely illustrative and not intended to limit the present invention to the following contents. The present invention can be appropriately modified within the scope of this disclosure.

### [Flexographic Printing Original Plate]

A flexographic printing original plate of the present embodiment includes a support, and a photosensitive resin composition layer stacked on the support.

The photosensitive resin composition layer contains a thermoplastic elastomer (a), a photopolymerizable unsaturated monomer (b), a photopolymerization initiator (c), and a plasticizer (d).

The thermoplastic elastomer (a) is a block copolymer that has a polymer block (A) principally containing at least one vinyl aromatic monomer unit and a polymer block (B) principally containing at least one conjugated diene monomer unit, and that is represented by either of the following general formulas (I) and (II). The thermoplastic elastomer (a) has a weight average molecular weight of 100,000 or more and 200,000 or less, and a content of a vinyl aromatic monomer unit in the thermoplastic elastomer (a) is 25.0% by mass or more, and a content of vinyl bond based on a conjugated diene monomer unit in the thermoplastic elastomer (a) is 12.0% by mass or less.

The thermoplastic elastomer (a) is less than 50 parts by mass based on 100 parts by mass of the photosensitive resin composition.

The plasticizer (d) contains polybutadiene containing 70.0% by mass or more of cis-form, and a content of vinyl bond based on a conjugated diene monomer unit in the plasticizer (d) is less than 5.0% by mass.

(A-B)ₙ (I)

(A-B)ₙX (II)

In the general formulas (I) and (II), A represents the polymer block (A), B represents the polymer block (B), X represents a residue of a coupling agent or a residue of a polymerization initiator, and n represents an integer of 1 to 2.

Since the flexographic printing original plate of the present embodiment has the above-described structure, it is possible to obtain an effect that a flexographic printing plate capable of attaining both ink filling inhibition and ink transferability in printing on low grade corrugated board, capable of retaining durability after long term storage, and having high productivity in plate-making can be obtained.

The flexographic printing plate (hereinafter sometimes simply referred to as the "printing plate") which attains both ink filling inhibition and ink transferability and which is capable of retaining the durability after long term storage and having high productivity in plate-making can be obtained probably owing to the following factor. It is noted that the factor is not limited to the following.

In order to transfer an ink onto a roughened paper surface, it is preferable that the surface of a flexographic printing plate is deformed to follow irregularities of the roughness when the surface of the flexographic printing plate comes into contact with the paper.

In order to easily deform the surface of the flexographic printing plate, it is effective to decrease a ratio of the thermoplastic elastomer (a) in the photosensitive resin composition layer or to decrease a ratio of the polymer block (A) principally containing a vinyl aromatic monomer unit in the thermoplastic elastomer (a). When such a method is employed, however, the flexographic printing plate becomes brittle to deteriorate the durability in printing, and thus, there is a problem that the method is not practical.

On the other hand, in order to improve the durability of the flexographic printing plate, it is effective to increase the content of vinyl bond based on a conjugated diene monomer unit in the thermoplastic elastomer (a) in the photosensitive resin composition layer, or to increase the content of vinyl bond in the plasticizer (d). When such a method is employed, however, cross-linking easily proceeds through a radical reaction when exposure is performed in a plate-making step of the flexographic printing plate, and hence an open reverse character is easily filled, and there arises a problem that ink filling is easily caused in printing.

In the flexographic printing original plate of the present embodiment, with retaining a high ratio of the polymer block (A) principally containing a vinyl aromatic monomer unit in the thermoplastic elastomer (a), cohesion between vinyl aromatic portions through intermolecular interaction is reduced, and thus, the above-described trade-off relationship is eliminated.

A factor in reduction of the cohesion between vinyl aromatic portions through the intermolecular interaction can be the following mechanism.

The structure of the thermoplastic elastomer (a) is limited to the block copolymer represented by either of (A-B)ₙ (I) and (A-B)ₙX (II) (wherein A represents the polymer block (A), B represents the polymer block (B), X represents a residue of a coupling agent or a residue of a polymerization initiator, and n represents an integer of 1 to 2), and thus is limited to a linear structure alone, and therefore, a vinyl aromatic portion is disposed outside the polymer block principally containing a conjugated diene monomer unit, and hence, the cohesion between vinyl aromatic portions through the intermolecular interaction can be probably made lower than in a cohesive radial structure having n of 3 or more.

Further, as the plasticizer (d) contained in the photosensitive resin composition layer, polybutadiene principally containing the cis-form, specifically, containing 70.0% by mass or more of the cis-form, is used. Therefore, in a process of kneading and dispersing a photosensitive resin composition, polybutadiene enters between vinyl aromatic portions to weaken the intermolecular interaction between the vinyl aromatic portions by steric hindrance, which probably lowers the cohesion.

Furthermore, in the radical reaction occurring in the exposure between the thermoplastic elastomer (a) and the polybutadiene, a 1,2-vinyl bond of the polybutadiene priorly cross-links, and cross-links also with 1,4-vinyl (trans-form), but a crosslinking reaction is minimally caused with 1,4-vinyl (cis-form) due to the steric hindrance. This is probably the reason why an open reverse character is minimally filled when the polybutadiene principally containing the cis-form is used.

In addition, when an ester compound containing an aliphatic saturated hydrocarbon such as a stearic acid derivative is used as an antiblocking agent of the thermoplastic elastomer (a), an aliphatic saturated hydrocarbon portion enters a gap formed by the steric hindrance in the "polybutadiene principally containing the cis-form" used as the plasticizer (d), so as to be compatible therewith. Thus, a rigid ester portion interacts with a vinyl aromatic monomer unit of the polymer block (B) principally containing a conjugated diene monomer unit, and hence the intermolecular interaction between vinyl aromatic monomer units of the polymer block (B) principally containing a conjugated diene monomer unit is weakened, which probably lowers the cohesion.

As described above, the ink transferability depends on deformation followability of the surface of the flexographic printing plate to the irregularities, and the ink filling property depends on the cross-linking property, and hence these properties are in the trade-off relationship. It is surprising that these properties can be both coped with by the structure of the photosensitive resin composition alone without employing the technique of forming microcells.

### (Support)

The support used in the flexographic printing original plate of the present invention is not especially limited as long as it can support the photosensitive resin composition layer described later.

As the support, for example, a polyester film is suitably used, and a polyethylene terephthalate film is more preferably used.

### (Photosensitive Resin Composition Layer)

The flexographic printing original plate of the present embodiment includes the photosensitive resin composition layer stacked on the support.

The photosensitive resin composition layer is obtained, for example, by forming a photosensitive resin composition constituting the photosensitive resin composition layer into a sheet shape, and bringing the resultant sheet into close contact with the support by roll lamination, followed by hot pressing after lamination. When this method is employed, a photosensitive resin composition layer excellent in thickness accuracy can be obtained.

The flexographic printing original plate of the present embodiment can be produced by any of various methods using the support and the photosensitive resin composition and the like used as raw materials of the photosensitive resin composition layer.

For example, raw materials of the photosensitive resin composition are dissolved in and mixed with an appropriate solvent, such as chloroform, tetrachloroethylene, methyl ethyl ketone or toluene, the resultant mixture is flow-casted in a mold, the solvent is evaporated to directly obtain a plate, and the plate is stacked on the support. Thus, the flexographic printing original plate can be obtained.

Alternatively, without using a solvent, the materials are kneaded using a kneader, a roll mill or a screw extruder, the resultant is molded into a desired thickness using a calendar roll or a press, and the resultant is stacked on the support. Thus, the flexographic printing original plate can be obtained.

It is noted that the flexographic printing original plate of the present embodiment is not limited to those obtained by these methods.

Since the photosensitive resin composition layer of the flexographic printing original plate usually has tackiness, in order to improve a contact property with a negative film overlapped thereon in plate-making, or in order to make a negative film reusable, a solvent-soluble thin flexible protective layer (see, for example, Japanese Patent Publication No. 5-13305) may be further provided on the surface of the photosensitive resin composition layer.

Alternatively, instead of this flexible protective layer, a UV shielding layer containing an infrared sensitive material may be provided so as to perform direct pattern drawing with infrared laser, and thus, the UV shielding layer itself may be used as a negative film.

In either case, when an unexposed portion of the photosensitive resin composition layer is washed out in a developing step following exposure, the thin flexible protective layer or the UV shielding layer is simultaneously removed.

When, for example, a layer of polyamide, partially saponified polyvinyl acetate, cellulose ester or the like soluble in a washout solution used in development is formed on the surface of the photosensitive resin composition layer as the solvent-soluble thin flexible protective layer, a solution obtained by dissolving such a substance in an appropriate solvent may be directly coated on the photosensitive resin composition layer to form the protective layer. Alternatively, the layer of polyamide, partially saponified polyvinyl acetate, cellulose ester or the like may be coated on a prescribed film of polyester, polypropylene or the like to obtain a protective film, and the protective film may be laminated or press-bonded onto the photosensitive resin composition layer to be transferred as the protective layer. In this case, the protective layer is obtained by forming, on the support, the photosensitive resin composition layer in the shape of a sheet, and bringing the resultant into close contact with the protective film by roll lamination, followed by hot pressing after lamination.

### <Thermoplastic Elastomer (a)>

The photosensitive resin composition layer contains the thermoplastic elastomer (a).

The thermoplastic elastomer (a) means a polymer that can be plasticized to be molded at a high temperature and exhibits properties as an elastic body at normal temperature.

The thermoplastic elastomer (a) is a block copolymer that has the polymer block (A) principally containing at least one vinyl aromatic monomer unit, and the polymer block (B) principally containing at least one conjugated diene monomer unit, and that is represented by either of the following general formulas (I) and (II).

The term "to principally contain" herein refers to a content of 70% by mass or more.

(A-B)ₙ (I)

(A-B)ₙX (II)

In the general formulas (I) and (II), A represents the polymer block (A), B represents the polymer block (B), X represents a residue of a coupling agent or a residue of a polymerization initiator, and n represents an integer of 1 to 2.

A vinyl aromatic monomer constituting the polymer block (A) principally containing a vinyl aromatic monomer unit is not especially limited, and can be, for example, styrene, p-methylstyrene, tert-butylstyrene, α-methylstyrene and 1,1-diphenylethylene, and is preferably styrene from the viewpoint of availability.

One of these may be singly used, or two or more of these may be used in combination.

A content of a vinyl aromatic monomer unit in the thermoplastic elastomer (a) is, in 100% by mass of the thermoplastic elastomer (a), 25.0% by mass or more, preferably 26.0% by mass or more, and more preferably 27.0% by mass or more from the viewpoint of cold flow resistance of an uncured resin structure and the chipping resistance.

The content of a vinyl aromatic monomer unit in the thermoplastic elastomer (a) can be controlled to fall in the numerical range by adjusting the ratio between a vinyl aromatic monomer and a conjugated diene monomer added at the time of synthesis.

A conjugated diene monomer constituting the polymer block (B) principally containing a conjugated diene monomer unit is not especially limited, and can be, for example, butadiene, isoprene and/or a hydrogenated product thereof.

One of these may be singly used, or two or more of these may be used in combination.

Further, hydrogenation of a conjugated diene monomer unit may be performed after producing a block copolymer containing a vinyl aromatic monomer unit.

The conjugated diene monomer is preferably butadiene and/or a hydrogenated product thereof from the viewpoint of viscosity decrease on the surface of the photosensitive resin composition layer, wear resistance of the flexographic printing plate, or the chipping resistance.

The content of vinyl bond based on a conjugated diene monomer unit in the thermoplastic elastomer (a) is, with respect to 100% by mass of the thermoplastic elastomer (a), 12.0% by mass or less, preferably 10.0% by mass or less, and more preferably 8.0% by mass or less from the viewpoint of an open reverse property of a relief pattern.

The content of vinyl bond based on a conjugated diene monomer unit in the thermoplastic elastomer (a) can be controlled to fall in the numerical range by adjusting the amount of N,N,N',N'-tetramethylethylenediamine (hereinafter also referred to as "TMEDA") used at the time of synthesis.

The thermoplastic elastomer (a) may further contain, if necessary, a block principally containing ethylene or propylene.

A weight average molecular weight of the thermoplastic elastomer (a) is, in terms of standard polystyrene, using gel permeation chromatography (GPC), 100,000 or more and 200,000 or less from the viewpoint of obtaining good balance between moldability and solid retainability of the photosensitive resin composition, is preferably 105,000 or more and 180,000 or less, and more preferably 110,000 or more and 170,000 or less from the viewpoint of the chipping resistance and meltability at the time of molding.

The weight average molecular weight of the thermoplastic elastomer (a) can be controlled to fall in the numerical range by adjusting various conditions in a polymerization process such as added amounts of monomers, polymerization time, and a polymerization temperature.

The thermoplastic elastomer (a) is used, from the viewpoint of moldability and hardness of the flexographic printing plate, in an amount less than 50 parts by mass, preferably less than 45 parts by mass, and more preferably 42 parts by mass or less based on 100 parts by mass of the photosensitive resin composition.

From the viewpoints of the moldability and cold flow, the amount is preferably 30 parts by mass or more, more preferably 35 parts by mass or more, and further preferably 37 parts by mass or more.

The photosensitive resin composition layer can contain another elastomer (second elastomer) in addition to the thermoplastic elastomer (a).

The second elastomer is used, from the viewpoint of compatibility of the resin, in an amount of preferably 20 parts by mass or less, more preferably 15 parts by mass or less, and further preferably 10 parts by mass or less based on 100 parts by mass of the photosensitive resin composition.

Examples of the second elastomer include polyolefin, polyester, and polyurethane.

Further, from the viewpoint of preventing blocking during storage, an antiblocking agent is preferably contained in the thermoplastic elastomer (a).

Examples of the antiblocking agent include a stearic acid salt, a stearic acid derivative and a silica particle.

From the viewpoints of reducing the cohesion of the polymer block (A) principally containing a vinyl aromatic monomer unit in the thermoplastic elastomer (a), making the surface of the flexographic printing plate flexible, and increasing the ink transferability onto a roughened paper surface, a stearic acid salt and/or a stearic acid derivative is preferably used.

### <Photopolymerizable Unsaturated Monomer (b)>

The photosensitive resin composition layer contains the photopolymerizable unsaturated monomer (b).

The photopolymerizable unsaturated monomer (b) refers to a compound having a radical polymerizable unsaturated double bond.

Examples of the photopolymerizable unsaturated monomer (b) include, but are not limited to, olefins such as ethylene, propylene, vinyl toluene, styrene and divinylbenzene; acetylenes; (meth)acrylic acid and/or a derivative thereof; halo-olefins; unsaturated nitriles such as acrylonitrile; derivatives of acrylamide and methacrylamide; unsaturated dicarboxylic acid such as maleic anhydride, maleic acid or fumaric acid, and a derivative thereof; vinyl acetates; N-vinylpyrrolidone; N-vinylcarbazole; and a N-substituted maleimide compound.

In particular, (meth)acrylic acid and/or a derivative thereof is preferably used because of their abundant types.

Examples of the derivative include, but are not limited to, an alicyclic compound having a cycloalkyl group, a bicycloalkyl group, a cycloalkenyl group, a bicycloalkenyl group or the like; an aromatic compound having a benzyl group, a phenyl group, a phenoxy group, or a naphthalene skeleton, an anthracene skeleton, a biphenyl skeleton, a phenanthrene skeleton, a fluorene skeleton or the like; a compound having an alkyl group, a halogenated alkyl group, an alkoxy alkyl group, a hydroxyalkyl group, an aminoalkyl group, a glycidyl group or the like; an ester compound, with polyhydric alcohol, of alkylene glycol, polyoxyalkylene glycol, polyalkylene glycol, trimethylolpropane or the like; and a compound having a polysiloxane structure such as polydimethylsiloxane or polydiethylsiloxane.

Alternatively, it may be a heteroaromatic compound containing an element such as nitrogen or sulfur.

Examples of the (meth)acrylic acid and/or a derivative thereof include, but are not limited to, diacrylate and dimethacrylate of alkanediol such as hexanediol and nonanediol; diacrylate and dimethacrylate of ethylene glycol, diethylene glycol, propylene glycol, dipropylene glycol, polyethylene glycol, and butylene glycol; trimethylolpropane tri(meth)acrylate; dimethylol tricyclodecane di(meth)acrylate; isobornyl (meth)acrylate; phenoxypolyethylene glycol (meth)acrylate; and pentaerythritol tetra(meth)acrylate.

One of these may be singly used, or two or more of these may be used in combination.

From the viewpoint of photo-curing property, the photopolymerizable unsaturated monomer (b) is contained in an amount of preferably 1 to 20 parts by mass, more preferably 2 to 15 parts by mass, and further preferably 3 to 12 parts by mass based on 100 parts by mass of the photosensitive resin composition layer.

In particular, a diacrylate monomer is preferably contained in the numerical range as the photopolymerizable unsaturated monomer (b).

### <Photopolymerization Initiator (c)>

The photosensitive resin composition layer contains the photopolymerization initiator (c).

The photopolymerization initiator (c) means a compound absorbing light energy to generate a radical.

As the photopolymerization initiator (c), any of various types of known initiators can be used, and various organic carbonyl compounds, particularly aromatic carbonyl compounds are suitably used.

Examples of the photopolymerization initiator (c) include, but are not limited to, thioxanthones such as benzophenone, 4,4-bis(diethylamino)benzophenone, t-butylanthraquinone, 2-ethylanthraquinone, 2,4-diethylthioxanthone, isopropylthioxanthone, and 2,4-dichlorothioxanthone; acetophenones such as diethoxyacetophenone, 2,2-dimethoxy-1,2-diphenylethan-1-one, 2-hydroxy-2-methyl-1-phenylpropan-1-one, benzyl dimethyl ketal, 1-hydroxycyclohexyl-phenyl ketone, 2-methyl-2-morpholino(4-thiomethylphenyl)propan-1-one, and 2-benzyl-2-dimethylamino-1-(4-morpholinophenyl)-butanone; benzoin ethers such as benzoin methyl ether, benzoin ethyl ether, benzoin isopropyl ether, and benzoin isobutyl ether; acylphosphine oxides such as 2,4,6-trimethylbenzoyl diphenylphosphine oxide, bis(2,6-dimethoxybenzoyl)-2,4,4-trimethylpentylphosphine oxide, and bis(2,4,6-trimethylbenzoyl)-phenylphosphine oxide; methyl benzoylformate; 1,7-bisacrydinyl heptane; and 9-phenylacridine.

One of these may be singly used, or two or more of these may be used in combination.

The photosensitive resin composition layer preferably contains at least two or more photopolymerization initiators (c), and a specific example includes a combination of 2,2-dimethoxy-1,2-diphenylethan-1-one and 2-benzyl-2-dimethylamino-4'-morpholinobutyrophenone.

The content of the photopolymerization initiator (c) is, based on 100 parts by mass of the photosensitive resin composition layer, preferably 1.0 part by mass or more and 5.0 parts by mass or less, more preferably 1.2 parts by mass or more and 4.0 parts by mass or less, and further preferably 1.5 parts by mass or more and 3.5 parts by mass or less because when the content is equal to or higher than the prescribed lower limit, deterioration in formability of fine dots and characters is restrained, and when it is equal to or lower than the prescribed upper limit, deterioration in transmittance of active light such as UV is restrained.

### <Plasticizer (d)>

The photosensitive resin composition layer contains the plasticizer (d).

The plasticizer (d) means a conjugated diene rubber and/or a hydrocarbon compound.

A conjugated diene rubber can be obtained from a conjugated diene compound.

Examples of the conjugated diene compound include, but are not limited to, monomers such as 1,3-butadiene, isoprene, 2,3-dimethyl-1,3-butadiene, 2-methyl-1,3-pentadiene, 1,3-hexadiene, 4,5-diethyl-1,3-octadiene, 3-butyl-1,3-octadiene, and chloroprene.

As the conjugated diene compound, isoprene and/or butadiene are preferred from the viewpoint of availability, and butadiene is more preferred from the viewpoint of the chipping resistance.

One of these monomers may be singly used, or two or more of these may be used together.

In the present embodiment, polybutadiene containing 70.0% by mass or more of the cis-form is used as the plasticizer (d).

Thus, the cohesion of the polymer block (A) principally containing a vinyl aromatic monomer unit in the thermoplastic elastomer (a) can be reduced, the surface of a flexographic printing plate can be made flexible, and the ink transferability onto a roughened paper surface can be improved.

The content of the "polybutadiene containing 70.0% by mass or more of the cis-form" in the plasticizer (d) is preferably 30% by mass or more and 100% by mass or less, more preferably 40% by mass or more and 99% by mass or less, and further preferably 50% by mass or more and 98% by mass or less.

The content of vinyl bond based on a conjugated diene monomer unit in the plasticizer (d) is less than 5% by mass, preferably less than 2% by mass, and more preferably 1% by mass or less from the viewpoint of increasing an open reverse depth of a relief pattern and inhibiting ink filling.

The content of vinyl bond based on a conjugated diene monomer unit in the plasticizer (d) can be obtained using proton NMR (nuclear magnetic resonance spectrum).

Further, the content of vinyl bond based on a conjugated diene monomer unit in the plasticizer (d) can be controlled to fall in the numerical range by adjusting the amount of a catalyst used at the time of synthesis.

A weight average molecular weight (Mw) of the conjugated diene rubber used as the plasticizer (d) is preferably lower from the viewpoint of handleability and compatibility of the photosensitive resin compound, and is preferably higher from the viewpoint of the chipping resistance. The weight average molecular weight is preferably 1,000 to 30,000, more preferably 1,200 to 20,000, and further preferably 1,500 to 12,000.

The weight average molecular weight of the conjugated diene rubber used as the plasticizer (d) can be measured by the gel permeation chromatography (GPC) similarly to the measurement of the weight average molecular weight of the thermoplastic elastomer (a).

The content of the conjugated diene rubber used as the plasticizer (d) is, with respect to a total amount (100% by mass) of the photosensitive resin composition layer, preferably 3.0% by mass or more from the viewpoints of image reproducibility, the chipping resistance and the flexibility, and preferably 40% by mass or less, more preferably 5.0 to 30% by mass, and further preferably 7.0 to 20% by mass from the viewpoint of the solid retainability of the flexographic printing original plate.

The hydrocarbon compound used as the plasticizer (d) is not especially limited, and can be, for example, a resin substantially composed of carbon and hydrogen, and examples include a paraffin-based hydrocarbon, an olefin-based hydrocarbon, and a naphthene-based hydrocarbon.

One of these may be singly used, or two or more of these may be used in combination.

The paraffin-based hydrocarbon is a saturated chain compound represented by a molecular formula, CₙH₂ₙ₊₂, and is divided into non-branched normal paraffin and branched isoparaffin.

The olefin-based hydrocarbon is a chain hydrocarbon having a double bond, and is represented by a general formula, CₙH₂ₙ when the number of double bonds is one.

The naphthene-based hydrocarbon is a hydrocarbon containing at least one saturated ring (naphthene ring) in one molecule, and is represented by a general formula, CₙH₂ₙ. Naphthene-based hydrocarbons present in crude oil and petroleum products are divided into one containing 2 or 3 naphthene rings linked to each other, one condensed with an aromatic ring, one containing various paraffin side chains added to the naphthene ring or condensed ring, and the like.

The content of the hydrocarbon compound used as the plasticizer (d) is preferably 40% by mass or less, more preferably 30% by mass or less, and further preferably 25% by mass or less from the viewpoint of the solid retainability of the flexographic printing original plate.

The photosensitive resin composition layer included in the flexographic printing original plate of the present embodiment can further contain, in accordance with desired characteristics, various auxiliary additive components, such as a plasticizer different from the plasticizer (d), a thermal polymerization inhibitor, a UV absorber, an antihalation agent, a light stabilizer, and an antioxidant.

### (Production Method for Photosensitive Resin Composition Layer)

The photosensitive resin composition layer can be produced by any of various methods.

For example, the photosensitive resin composition layer can be produced by dissolving and mixing the photosensitive resin composition containing the thermoplastic elastomer (a), the photopolymerizable unsaturated monomer (b), the photopolymerization initiator (c) and the plasticizer (d) in and with a prescribed solvent such as chloroform, tetrachloroethylene, methyl ethyl ketone or toluene, flow-casting the resultant mixture in a mold, and evaporating the solvent to directly obtain a plate.

Alternatively, the photosensitive resin composition layer can be produced, without using a solvent, by kneading the photosensitive resin composition using a kneader, a roll mill or a screw extruder, and molding the resultant into a plate having a desired thickness.

### [Production Method for Flexographic Printing Original Plate]

The flexographic printing original plate of the present embodiment can be produced, for example, by the following method.

The flexographic printing original plate can be produced by applying photosensitive resin composition components constituting the photosensitive resin composition layer onto the support, or providing the photosensitive resin composition layer on the support using an extruder, injection molding or press molding, and laminating the thus obtained photosensitive resin composition layer to be in contact with a non-infrared shielding layer or UV absorbing layer formed on a film.

### [Flexographic Printing Plate]

The flexographic printing plate is produced by plate-making from the flexographic printing original plate (photosensitive structure for a flexographic printing plate) of the present embodiment described above.

As a general method for obtaining, by plate-making, the flexographic printing plate from the flexographic printing original plate, first, a thin uniform cured layer is provided by performing UV exposure (back exposure) on the entire surface through the support. Next, through a negative film, or directly from above the UV shielding layer, image exposure (relief exposure) is performed on the surface of the photosensitive resin composition layer, and an unexposed portion is washed away using a developing solvent, or is absorption removed using an absorption layer after thermal melting, followed by post-exposure. The term "cured layer" used herein means a layer, included in the photosensitive resin composition layer, cured through, for example, irradiation with UV.

Specifically, the flexographic printing plate can be produced by the following method.

First, a thin uniform cured layer is provided by photo-curing the photosensitive resin composition layer by exposure through the support of the flexographic printing original plate (back exposure).

When a non-infrared shielding layer is stacked on the photosensitive resin composition layer on the flexographic printing original plate and a film is stuck onto the non-infrared shielding layer, the film is first peeled off.

Thereafter, the non-infrared shielding layer is subjected to pattern irradiation with infrared to form a mask on the photosensitive resin composition layer.

An infrared laser suitably used can be, for example, a ND/YAG laser (of, for example, 1064 nm) or a diode laser (of, for example, 830 nm).

For infrared laser ablation technique employed here, an adequate laser system is commercially available, and for example, laser diode system CDI Spark (manufactured by ESKO GRAPHICS) can be used.

This laser system includes a rotary cylindrical drum for holding a flexographic printing original plate, an IR laser irradiation device, and a layout computer, and image information is directly transmitted from the layout computer to the laser device.

After drawing a pattern on the non-infrared shielding layer, the entire surface of the photosensitive resin composition layer is irradiated with UV.

As an irradiation unit used here, a unit similar to that used in the UV irradiation from the side of the support can be used.

Examples of a light source used for photo-curing the photosensitive resin composition layer include, but are not limited to, a high pressure mercury lamp, a UV fluorescent lamp, a carbon arc lamp, a xenon lamp, and sunlight.

After this exposure of the entire surface, a development treatment for washing out an unexposed portion is performed.

Examples of a development solvent include, but are not limited to, chlorine-based organic solvents such as 1,1,1-trichloroethane and tetrachloroethylene; esters such as heptyl acetate and 3-methoxybutyl acetate; hydrocarbons such as petroleum distillate, toluene and decalin; and a mixture of any of these with an alcohol such as propanol, butanol or pentanol.

An unexposed portion may be washed away by spraying from a nozzle or by brushing with a brush.

After the development treatment, rinsing and drying steps are performed, followed by post-exposure, and the resultant is subjected to a prescribed treatment to obtain the flexographic printing plate.

### EXAMPLES

The present invention will be hereinafter described in detail with reference to specific examples and comparative examples, and it is noted that the present invention is not limited to the following examples.

### [Constituent Materials of Flexographic Printing Original Plate and Flexographic Printing Plate]

### (Preparation of Photosensitive Resin Composition)

Thermoplastic elastomers (a) shown in Table 1 below (shown as A to G in Table 1) were used to be mixed, in accordance with compositions shown in Tables 2 and 3 below, with a photopolymerizable unsaturated monomer (b), a photopolymerization initiator (c), plasticizers (d) and an antioxidant, and the resultants were sufficiently stirred to obtain photosensitive resin compositions.

The details of the materials used for preparing the photosensitive resin compositions are as follows:
(Thermoplastic Elastomers (a): A to G shown in Table 1)
SBS-A (styrene-butadiene copolymer)
SBS-B (styrene-butadiene copolymer)
SBS-C (styrene-butadiene copolymer)
SBS-D (styrene-butadiene copolymer)
SBS-E (styrene-butadiene copolymer)
SBS-F (styrene-butadiene copolymer)
SBS-G (styrene-butadiene copolymer)

### <Analysis of Thermoplastic Elastomer (a)>

### [(1) Content of Vinyl Aromatic Monomer Unit (Styrene)]

A content of a vinyl aromatic monomer unit in the thermoplastic elastomer was calculated based on absorption intensity at 262 nm measured using a UV spectrophotometer (Hitachi UV200).

### [(2) Weight Average Molecular Weight of Thermoplastic Elastomer]

A weight average molecular weight of the thermoplastic elastomer was obtained based on a chromatogram obtained through measurement by gel permeation chromatography (GPC, measurement apparatus: manufactured by Waters, column: combination of three MINIMIX columns manufactured by Polymer Laboratories; solvent: tetrahydrofuran, measurement conditions: temperature of 35°C, flow rate of 0.4 mL/min, sample concentration of 0.1% by mass, injection amount of 40 µL).

The weight average molecular weight herein refers to a converted value based on a calibration curve obtained through measurement using standard polystyrene having the following weight average molecular weights (manufactured by Waters, 1.54 x 10⁶, 4.1 x 10⁵, 1.10 x 10⁵, 3.5 x 10⁴, 8.5 x 10³, 1.8 x 10³).

### [(3) Amount of Vinyl Bond based on Conjugated Diene Monomer Unit]

A content of vinyl bond based on a conjugated diene monomer unit was obtained based on a peak area ratio obtained through measurement of proton NMR (nuclear magnetic resonance spectrum) at 400 Hz.

### [(4) Diblock Content]

A diblock content was obtained, similarly to the weight average molecular weight of the thermoplastic elastomer, based on the chromatogram obtained through the measurement by gel permeation chromatography (GPC, measurement apparatus: manufactured by Waters, column: combination of three MINIMIX columns manufactured by Polymer Laboratories; solvent: tetrahydrofuran, measurement conditions: temperature of 35°C, flow rate of 0.4 mL/min, sample concentration of 0.1% by mass, injection amount of 40 µL).

### <Synthesis of Thermoplastic Elastomer (a)>

After sufficient nitrogen replacement in a 10 L stainless steel reactor equipped with a jacket and a stirrer, 6,500 g of cyclohexane, 1.2 g of tetrahydrofuran and 300 g of styrene were charged therein, and the temperature of the contents was set to about 55°C by causing warm water to pass through the jacket.

Thereafter, a n-butyllithium cyclohexane solution (purity content: 0.96 g) and N,N,N',N'-tetramethylethylenediamine (hereinafter also referred to as "TMEDA") in a ratio of 0.02 mol with respect to 1 mol of n-butyllithium were charged, and polymerization of styrene was started.

Three minutes after styrene was substantially completely polymerized, 700 g of butadiene (1,3-butadiene) was added to continue the polymerization, and four minutes after butadiene was substantially completely polymerized to reach a maximum temperature of about 90°C, 1.25 g of dibromoethane was added as a coupling agent to cause a coupling reaction.

The system was continuously stirred by the stirrer from immediately after charging styrene until this point.

The thus obtained solution of a block copolymer was extracted, 10 g of water was added thereto, followed by stirring. Then, 3.0 g of n-octadecyl-3-(3'-5'-di-tert-butyl-4'-hydroxyphenyl)propionate and 1.5 g of 2,4-bis(n-octylthiomethyl)-O-cresol were added to obtained a mixed solution, and the solution was subjected to steam stripping to remove the solvent, and thus, hydrous crumb was obtained.

Subsequently, the hydrous crumb was dehydrated and dried using a heated roll, 0.1 g of calcium stearate was mixed therewith as an antiblocking agent, and thus, a sample of the thermoplastic elastomer (a) having analysis values of SBS-A was obtained.

Samples of SBS-B and SBS-C were obtained by performing the synthesis in the same manner except that the amount of charged SBS-A was changed.

Samples of SBS-D and SBS-F were obtained by performing the synthesis in the same manner except that the amount of charged SBS-A was changed, and that EBS (ethylene bis stearic acid compound) was used as the antiblocking agent.

A sample of SBS-G was obtained by performing the synthesis in the same manner as SBS-A except that a silica particle was used as the antiblocking agent.

A sample of SBS-E was obtained by performing the synthesis in the same manner except that the amount of charged SBS-A was changed, that tetramethoxysilane was used as the coupling agent, and that EBS was used as the antiblocking agent.

The thus obtained thermoplastic elastomers (a) are shown in Table 1.

### (Photopolymerizable Unsaturated Monomer (b)) 1,9-nonanediol acrylate

### (Photopolymerization Initiator (c)) 2,2-dimethoxy-1,2-diphenylethan-1-one

### (Antioxidant) 2,6-di-tert-butyl-4-methylphenol

### (Plasticizer (d))

Polybutadiene A: cis-form: 74% by mass, weight average molecular weight: 1600, content of 1,2-vinyl bond: 1% by mass
Polybutadiene B: cis-form: 80% by mass, weight average molecular weight: 3000, content of 1,2-vinyl bond: 1% by mass
Polybutadiene C: cis-form: 0% by mass, weight average molecular weight: 2000, content of 1,2-vinyl bond: 90% by mass

### (Cleaning Solution)

### 3-methoxybutyl acetate

### [Production of Flexographic Printing Original Plate]

Each of the thermoplastic elastomers (a) (shown as A to G in Table 1) was used, the raw materials of the photosensitive resin composition shown in Table 2 were charged in a kneader (FM-MW-3, manufactured by Powrex Corp.), and the resultant was mixed and kneaded at 180°C for 60 minutes to obtain a photosensitive resin composition.

The thus obtained photosensitive resin composition was disposed between a polyester film support coated with an adhesive for a photosensitive resin and having a thickness of 125 µm, and a polyester cover sheet having a thickness of 100 µm and including a polyamide layer with a thickness of 4 µm. To the resultant, a pressure of 200 kg/cm² was applied by a press machine for 4 minutes at 130°C with a spacer of 4 mm used, and thus, the flexographic printing original plate was produced.

### [Production of Flexographic Printing Plate]

The cover sheet was peeled off from the flexographic printing original plate, a negative film was brought into close contact on the photosensitive resin composition layer, and the entire surface was exposed, on an exposure device "AFP-1216E" (trade name, manufactured by Asahi Kasei Corporation), at 600 mJ/cm² first from the side of the support by using a lower UV lamp (UV lamp TL80W/10R, trade name, manufactured by PHILIPS) to obtain a relief depth of 1.6 mm.

Subsequently, an upper lamp (UV lamp TL80W/10R, trade name, manufactured by PHILIPS) was used for irradiation with UV at 8000 mJ/cm² from a side of a black layer. Exposure intensity obtained at this point was measured using a UV luminometer MO-2 manufactured by ORC Manufacturing Co., Ltd. (UV-35 filter, trade name, manufactured by ORC Manufacturing Co., Ltd.).

Subsequently, a developing apparatus "AFP-1321P" (trade name, manufactured by Asahi Kasei Corporation) was used to perform development at a liquid temperature of 30°C at a prescribed speed, and the resultant was dried at 60°C for 2 hours.

Thereafter, as a post-exposure treatment, exposure was performed with 1,000 mJ/cm² on the entire surface of the photosensitive resin plate after drying by using the exposure device AFP-1216F (trade name, manufactured by Asahi Kasei Corporation) using a germicidal lamp (GL-30, trade name, manufactured by Toshiba Corp.) having a center wavelength of 254 nm. An amount of the post-exposure with the germicidal lamp at this point was calculated based on illuminance measured using a UV-25 filter of "UV-MO2".

### [Evaluation Methods employed in Examples and Comparative Examples]

### (Development Speed)

A flexographic printing original plate having a thickness of 4.00 mm not exposed was cut into a size of 5 cm x 5 cm, the development was performed with a feed speed of the flexographic printing original plate set to any of three conditions of 75 mm/min, 100 mm/min and 150 mm/min, the resultant was dried at 60°C for 2 hours, and the thickness was measured. Thus, a calibration curve of a relationship between the feed speed of the flexographic printing original plate and a thickness change caused through the development was created.

A feed speed of the flexographic printing original plate to obtain a thickness change caused through the development of 1.6 mm was calculated based on the calibration curve, and a reciprocal of the calculated value was defined as the development speed.

### <Evaluation Criteria>

With a development speed of Comparative Example 1 used as a reference, evaluation was made based on the following criteria:
×: The development speed is less than 100%.
Δ : The development speed is 100% or more and less than 105%.
○ :The development speed is 105% or more and less than 125%.
⊚ : The development speed is 125% or more.

### (Open reverse Depth)

In order to measure an open reverse depth of a flexographic printing plate, a flexographic printing plate was obtained by plate-making using a negative film having fine lines with a width of 1500 µm, and a depth in the depth direction in the width of 1,500 µm was measured using a depth and height measuring apparatus (µDEPTH & HEIGHT MEASURING SCOPE, manufactured by Nisshooptical Co., Ltd.).

### <Evaluation Criterion>

× : less than 600 µm
Δ : 600 µm or more and less than 650 µm
○ : 650 µm or more and less than 750 µm
⊚ : 750 µm or more

### (Print Density)

The thus obtained flexographic printing plate having a thickness of 3.94 mm was used to perform a print test using a flexographic printing machine.

A negative film used in producing the flexographic printing plate had an entirely cured pattern (in a size of 10 cm x 75 cm).

WASSER SUPER-Z plus 3L (trade name, manufactured by Osaka Printing Ink Mfg. Co., Ltd.) was used as an ink, an A flute sheet (corrugating medium: 100 g) was used as a printing object, and an anilox roll of 250 lpi was used to perform printing on 10 sheets at a printing speed of 100 sheets/min, so as to evaluate print faint of a printed matter on the last sheet based on the following evaluation criterion:

### <Evaluation Criterion for Print Faint>

⊚ : An ink transfer area is 99% or more.
○ : An ink transfer area is 95% or more and less than 99%.
Δ : An ink transfer area is 90% or more and less than 95%.
× : An ink transfer area is less than 90%.

**[Table 1]**

| Thermoplastic Elastomer (a) | A | B | C | D | E | F | G |
|---|---|---|---|---|---|---|---|
| Weight Average Molecular Weight as whole (x 10000) | 11.5 | 15.1 | 12.0 | 14.4 | 25.0 | 9.0 | 11.5 |
| Content of Vinyl Aromatic Monomer Unit (mass%) | 28 | 31 | 31 | 30.5 | 22 | 20 | 28 |
| Content of Vinyl Bond based on Conjugated Diene Monomer Unit (mass%) | 9 | 9 | 8 | 11 | 14 | 30 | 9 |
| Diblock Content (mass%) | 17 | 16 | <1 | 20.5 | 17 | <1 | 17 |
| Antiblocking Agent | Ca Stearate | Ca Stearate | Ca Stearate | EBS | EBS | EBS | Silica |

**[Table 2]**

| Photosensitive Resin Composition | Example 1 | Example 2 | Example 3 | Example 4 | Example 5 | Example 6 | Example 7 | Example 8 |
|---|---|---|---|---|---|---|---|---|
| Thermoplastic Elastomer (a) | A | A | A | A | B | c | D | G |
| Thermoplastic Elastomer (a) [parts by mass] | 36 | 40 | 44 | 48 | 38 | 41 | 43 | 40 |
| Photopolymerizable Unsaturated Monomer (b) [parts by mass] 1,9-nonanediol acrylate | 6 | 6 | 6 | 6 | 6 | 6 | 6 | 6 |
| Photopolymerization Initiator (c) [parts by mass] 2,2-dimethoxy-1,2-diphenylethan-one | 2 | 2 | 2 | 2 | 2 | 2 | 2 | 2 |
| Plasticizer (d) [parts by mass] polybutadiene A, cis-form: 74 mass%, weight average molecular weight: 1600, content of vinyl bond: 1 mass% | 55 | 51 | 0 | 0 | 53 | 0 | 48 | 51 |
| Plasticizer (d) [parts by mass] polybutadiene B, cis-form: 80 mass%, weight average molecular weight: 3000, content of vinyl bond: 1 mass% | 0 | 0 | 47 | 43 | 0 | 50 | 0 | 0 |
| Plasticizer (d) [parts by mass] polybutadiene C, cis-form: 0 mass%, weight average molecular weight: 2000, content of vinyl bond: 90 mass% | 0 | 0 | 0 | 0 | 0 | 0 | 0 | 0 |
| Antioxidant [parts by mass] 2,6-di-tert-butyl-4-methylphenol | 1 | 1 | 1 | 1 | 1 | 1 | 1 | 1 |
| Print Density | ⊚ | ⊚ | ○ | Δ | ⊚ | ○ | ○ | ⊚ |
| Open reverse Depth | ⊚ | ⊚ | ○ | ○ | ⊚ | ○ | ○ | Δ |
| Development Speed (compared with Comparative Example 1) [%] | ⊚130% | ⊚120% | 0109% | Δ103% | ⊚122% | ⊚118% | ⊚113% | ⊚119% |

**[Table 3]**

| Photosensitive Resin Composition | Comparative Example 1 | Comparative Example 2 | Comparative Example 3 | Comparative Example 4 | Comparative Example 5 |
|---|---|---|---|---|---|
| Thermoplastic Elastomer (a) | A | A | E | E | F |
| Thermoplastic Elastomer (a) [parts by mass] | 50 | 39 | 55 | 44 | 37 |
| Photopolymerizable Unsaturated Monomer (b) [parts by mass] 1,9-nonanediol acrylate | 6 | 6 | 6 | 6 | 6 |
| Photopolymerization Initiator (c) [parts by mass] 2,2-dimethoan-1,2-diphenylethan-one | 2 | 2 | 2 | 2 | 2 |
| Plasticizer (d) [parts by mass] polybutadiene A, cis-form: 74 mass%, weight average molecular weight: 1600, content of vinyl bond: 1 mass% | 59 | 0 | 0 | 0 | 0 |
| Plasticizer (d) [parts by mass] polybutadiene B, cis-form: 80 mass%, weight average molecular weight: 3000, content of vinyl bond: 1 mass% | 0 | 0 | 0 | 0 | 0 |
| Plasticizer (d) [parts by mass] polybutadiene C, cis-form: 0 mass%, weight average molecular weight: 2000, content of vinyl bond: 90 mass% | 0 | 52 | 36 | 47 | 54 |
| Antioxidant [parts by mass] 2,6-di-tert-butyl-4-methylphenol | 1 | 1 | 1 | 1 | 1 |
| Print Density | × | ○ | × | ○ | ⊚ |
| Open reverse Depth | ○ | × | × | × | × |
| Development Speed (compared with Comparative Example 1) [%] | Δ 100% | Δ 105% | × 93% | ○110% | ○112% |

Since a printing plate applicable to printing on low grade corrugated board can be obtained from the flexographic printing original plate of the present invention, the present invention is industrially applicable widely in the field of commercial printing.

## Claims

1. A flexographic printing original plate, comprising:
a support; and
a photosensitive resin composition layer stacked on the support,
wherein the photosensitive resin composition layer contains:
a thermoplastic elastomer (a),
a photopolymerizable unsaturated monomer (b),
a photopolymerization initiator (c), and
a plasticizer (d),
the thermoplastic elastomer (a) is a block copolymer that has a polymer block (A) principally containing at least one vinyl aromatic monomer unit, and a polymer block (B) principally containing at least one conjugated diene monomer unit, and that is represented by either of the following general formulas (I) and (II),
the thermoplastic elastomer (a) has a weight average molecular weight of 100,000 or more and 200,000 or less,
a content of a vinyl aromatic monomer unit in the thermoplastic elastomer (a) is 25.0% by mass or more,
a content of vinyl bond based on a conjugated diene monomer unit in the thermoplastic elastomer (a) is 12.0% by mass or less,
the thermoplastic elastomer (a) is less than 50 parts by mass based on 100 parts by mass of the photosensitive resin composition,
the plasticizer (d) contains polybutadiene containing 70.0% by mass or more of cis-form, and
a content of vinyl bond based on a conjugated diene monomer unit in the plasticizer (d) is less than 5.0% by mass:
(A-B)ₙ (I)
(A-B)ₙX (II)
wherein A represents the polymer block (A), B represents the polymer block (B), X represents a residue of a coupling agent or a residue of a polymerization initiator, and n represents an integer of 1 to 2.

2. The flexographic printing original plate according to claim 1,
wherein the thermoplastic elastomer (a) contains a stearic acid salt or a stearic acid derivative as an antiblocking agent of the thermoplastic elastomer (a).

3. A method for producing a flexographic printing plate, comprising the following steps performed on the flexographic printing original plate according to any one of claims 1 to 3:
First, a thin uniform cured layer is provided by photo-curing the photosensitive resin composition layer by exposure through the support of the flexographic printing original plate, i.e. by back-exposure,
a step of performing pattern exposure by UV irradiation on the photosensitive resin composition layer; and
a step of removing an unexposed portion of the photosensitive resin composition layer.

## Patentansprüche

1. Flexodruck-Originaldruckplatte, mit:
einem Träger; und
einer fotoempfindlichen Harzzusammensetzungsschicht, die auf den Träger geschichtet ist,
wobei die fotoempfindliche Harzzusammensetzungsschicht enthält:
ein thermoplastisches Elastomer (a),
ein fotopolymerisierbares ungesättigtes Monomer (b),
einen Fotopolymerisationsinitiator (c), und
einen Weichmacher (d),
wobei das thermoplastische Elastomer (a) ein Blockcopolymer ist, das einen Polymerblock (A), der hauptsächlich mindestens eine vinylaromatische Monomereinheit enthält, und einen Polymerblock (B), der hauptsächlich mindestens eine konjugierte Dienmonomereinheit enthält, aufweist, und das durch eine der folgenden allgemeinen Formeln (I) und (II) dargestellt ist,
das thermoplastische Elastomer (a) ein Gewichtsmittel des Molekulargewichts von 100000 oder mehr und 200000 oder weniger aufweist,
ein Gehalt an einer vinylaromatischen Monomereinheit in dem thermoplastischen Elastomer (a) 25,0 Massen-% oder mehr ist,
ein Vinylbindungsanteil, bezogen auf eine konjugierte Dienmonomereinheit in dem thermoplastischen Elastomer (a), 12,0 Massen-% oder weniger ist,
das thermoplastische Elastomer (a) weniger als 50 Massenteile, bezogen auf 100 Massenteile der lichtempfindlichen Harzzusammensetzung, beträgt,
der Weichmacher (d) Polybutadien enthält, das 70,0 Massen-% oder mehr der cis-Form enthält, und
ein Vinylbindungsanteil, bezogen auf eine konjugierte Dienmonomereinheit in dem Weichmacher (d), weniger als 5,0 Massen-% beträgt:
(A-B)ₙ (I)
(A-B)ₙX (II)
wobei A den Polymerblock (A) darstellt, B den Polymerblock (B) darstellt, X einen Rest eines Kupplungsmittels oder einen Rest eines Polymerisationsinitiators darstellt und n eine ganze Zahl von 1 bis 2 darstellt.

2. Flexodruck-Originaldruckplatte nach Anspruch 1,
wobei das thermoplastische Elastomer (a) ein Stearinsäuresalz oder ein Stearinsäurederivat als Antiblockiermittel des thermoplastischen Elastomers (a) enthält.

3. Verfahren zur Herstellung einer Flexodruckplatte, mit den folgenden Schritten, die an der Flexodruck-Originaldruckplatte nach einem der Ansprüche 1 bis 3 durchgeführt werden:
zunächst wird eine dünne, gleichmäßige gehärtete Schicht mittels Fotohärten der fotoempfindlichen Harzzusammensetzungsschicht durch den Träger der Flexodruck-Originaldruckplatte, d.h. mittels Rückseiten-Belichtung, vorgesehen,
einem Schritt der Durchführung einer Musterbelichtung durch UV-Bestrahlung auf der fotoempfindlichen Harzzusammensetzungsschicht; und
einem Schritt des Entfernens eines nicht belichteten Bereichs der fotoempfindlichen Harzzusammensetzungsschicht.

## Revendications

1. Plaque originale d'impression flexographique, comprenant :
un support ; et
une couche de composition de résine photosensible superposée sur le support,
dans laquelle la couche de composition de résine photosensible contient :
un élastomère thermoplastique (a),
un monomère insaturé photopolymérisable (b),
un initiateur de photopolymérisation (c), et
un plastifiant (d),
l'élastomère thermoplastique (a) est un copolymère séquencé qui présente une séquence de polymère (A) contenant principalement au moins une unité monomère aromatique de vinyle, et une séquence de polymère (B) contenant principalement au moins une unité monomère de diène conjuguée, et qui est représenté par l'une ou l'autre des formules générales suivantes (I) et (II),
l'élastomère thermoplastique (a) présente un poids moléculaire moyen en poids égal à 100 000, ou plus et à 200 000, ou moins,
une teneur en unité monomère aromatique de vinyle dans l'élastomère thermoplastique (a) est de 25,0 % en masse, ou plus,
une teneur en liaison vinylique basée sur une unité monomère de diène conjuguée dans l'élastomère thermoplastique (a) est de 12,0 % en masse ou moins,
l'élastomère thermoplastique (a) est inférieur à 50 parties en masse sur la base de 100 parties en masse de la composition de résine photosensible,
le plastifiant (d) contient du polybutadiène contenant 70,0 % en masse, ou plus, de forme cis, et
une teneur en liaison vinylique basée sur une unité monomère de diène conjuguée dans le plastifiant (d) est inférieure à 5,0 % en masse :
(A-B)ₙ (I)
(A-B)ₙX (II)
,
dans lesquelles A représente la séquence de polymère (A), B représente la séquence de polymère (B), X représente un résidu d'un agent de couplage ou un résidu d'un initiateur de polymérisation, et n représente un entier de 1 à 2.

2. Plaque originale d'impression flexographique selon la revendication 1, dans laquelle l'élastomère thermoplastique (a) contient un sel d'acide stéarique ou un dérivé d'acide stéarique comme agent antibloquant de l'élastomère thermoplastique (a).

3. Procédé de production d'une plaque d'impression flexographique, comprenant les étapes suivantes exécutées sur la plaque originale d'impression flexographique selon l'une quelconque des revendications 1 à 2 :
premièrement, une couche durcie uniforme mince est formée par photodurcissement de la couche de composition de résine photosensible par une exposition à travers le support de la plaque originale d'impression flexographique, c'est-à-dire par exposition dorsale,
une étape d'exécution d'une exposition de motif par l'intermédiaire d'un rayonnement UV sur la couche de composition de résine photosensible ; et
une étape d'enlèvement d'une partie non exposée de la couche de composition de résine photosensible.
